# EUROPÄISCHE PATENTANMELDUNG

(11) **EP 4 633 301 A1**
(43) Veröffentlichungstag der Anmeldung: **15.10.2025**
(21) Anmeldenummer: 25168099.7
(22) Anmeldetag: 02.04.2025
(51) Int. Cl.: H05K 7/14

(54) **VERBINDUNGSVORRICHTUNG ZUR BEREITSTELLUNG EINER DEZENTRALEN AUTOMATISIERUNGSPLATTFORM**

(30) Priorität: 12.04.2024 DE 102024110296
(71) Anmelder: Murrelektronik GmbH, 71570 Oppenweiler (DE)
(72) Erfinder: Prein, Olaf, 32676 Lügde-Rischenau (DE); Feisst, Heiko, 73278 Schlierbach (DE); Roolf, Tim, 71522 Backnang (DE); Hoffmann, Luca, 71522 Backnang (DE)
(74) Vertreter: Bösherz Goebel Patentanwälte

(57) **Zusammenfassung**

Die Erfindung betrifft eine Verbindungsvorrichtung (10) zur Bereitstellung einer dezentralen Automatisierungsplattform (1), aufweisend:
- eine Anordnung von mehreren Haupt- und Nebenanschlüssen (50,55), die zum elektrischen Anschluss von mehreren Funktionsmodulen (200) in einem Anschlussbereich (A) der Verbindungsvorrichtung (10) vorgesehen sind,
- mehrere oder genau eine Hauptanschlussfläche (21), an welcher zumindest die Hauptanschlüsse (50) angeordnet sind,
- wenigstens eine Führungsfläche (80), die in einem definierten Winkel (W1) zur jeweiligen Hauptanschlussfläche (21) angeordnet ist, um die Funktionsmodule (200) in den Anschlussbereich (A) mechanisch zu führen und damit eine Montage der Funktionsmodule (200) zu unterstützen, die zum Anschluss an die Haupt- und/oder Nebenanschlüsse (50,55) vorgesehen ist,
- einen Grundkörper (20) mit einem Grundkörpergehäuse (30) und mit einer Verbindungsanordnung (40), wobei die Verbindungsanordnung (40) mit den Haupt- und/oder Nebenanschlüssen (50,55) elektrisch verbunden ist, um eine elektrische Verbindung für zumindest einen Teil der angeschlossenen Funktionsmodule (200) untereinander bereitzustellen,
- elektrische Leitungen (45) der Verbindungsanordnung (40), die im Grundkörpergehäuse (30) angeordnet sind, um einen Hauptenergiefluss, einen Hilfsenergiefluss und einen Datenfluss für die angeschlossenen Funktionsmodule (200) bereitzustellen, um die Automatisierungsplattform (1) zur Ansteuerung von elektrischen Geräten (300) einer industriellen Anlage zu betreiben.

## Beschreibung

Die vorliegende Erfindung betrifft eine Verbindungsvorrichtung zur Bereitstellung einer dezentralen Automatisierungsplattform. Ferner bezieht sich die Erfindung auf eine Automatisierungsplattform mit der Verbindungsvorrichtung, ein Funktionsmodul sowie ein Verfahren zum Betreiben einer Verbindungsvorrichtung.

### Stand der Technik

Aus dem Stand der Technik ist es bekannt, dass modulare Automatisierungslösungen dafür genutzt werden, um in einer industriellen Anlage elektrische Geräte über Energieleitungen mit Energie zu versorgen und über Steuerungsleitungen, wie z. B. Feldbusleitungen, anzusteuern. Die Modularität wird dabei oft dadurch erreicht, dass einzelne, voneinander unabhängige Funktionsmodule verwendet werden, die individuell konfiguriert und kombiniert werden können. Dies hat den Vorteil, dass die Automatisierungslösungen flexibel an die jeweiligen Anforderungen der industriellen Anlage angepasst werden können und somit eine hohe Effizienz und Wirtschaftlichkeit gewährleisten.

Die Druckschrift US 2013/0342152 A1 offenbart eine Mehrwellenmotorantriebsvorrichtung, bei welcher mindestens ein Verstärkermodul, ein Steuersubstrat und ein Leistungssubstrat vorgesehen sind.

Die Druckschriften WO 2012/000808 A1, WO 2023/088883 A1 und EP 2 728 673 B1 offenbaren weitere gattungsgemäße Lösungen.

Es ist bei herkömmlichen Lösungen häufig ein Problem, dass eine Montage von Funktionsmodulen einer Automatisierungsplattform aufwändig und fehleranfällig sein kann. Es ist daher eine Aufgabe der vorliegenden Erfindung, die voranstehend beschriebenen Nachteile zumindest teilweise zu beheben. Es ist insbesondere eine Aufgabe der vorliegenden Erfindung, die Verbindung von Funktionsmodulen mit einer gemeinsamen Verbindungsvorrichtung zu verbessern.

### Offenbarung der Erfindung

Gegenstand der Erfindung ist eine Verbindungsvorrichtung mit den Merkmalen des Anspruchs 1, eine Automatisierungsplattform mit den Merkmalen des Anspruchs 13 sowie ein Verfahren mit den Merkmalen des Anspruchs 14 und ein Funktionsmodul mit den Merkmalen des Anspruchs 15. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Verbindungsvorrichtung beschrieben sind, selbstverständlich auch im Zusammenhang mit der erfindungsgemäßen Automatisierungsplattform sowie dem erfindungsgemäßen Verfahren und dem erfindungsgemäßen Funktionsmodul, und jeweils umgekehrt, so dass bezüglich der Offenbarung zu den einzelnen Erfindungsaspekten stets wechselseitig Bezug genommen wird bzw. werden kann.

Gegenstand der Erfindung ist insbesondere eine Verbindungsvorrichtung zur Bereitstellung einer dezentralen Automatisierungsplattform. Die erfindungsgemäße Verbindungsvorrichtung weist insbesondere eine Anordnung von einem oder mehreren Haupt- und Nebenanschlüssen auf, die zum elektrischen Anschluss von einem oder mehreren Funktionsmodule(n) in einem Anschlussbereich der Verbindungsvorrichtung vorgesehen sind.

Unter einer dezentralen Automatisierungsplattform kann zumindest eine Hardware, ggf. mit einer zugehörigen Software, verstanden werden, um in einer elektrischen Anlage bestimmte Prozesse zu automatisieren. Bspw. werden hierbei Motoren, vorzugsweise Servomotoren, angesteuert, und mit diesen ein Roboterarm bewegt oder ein Förderband gesteuert. Die Verbindungsvorrichtung kann dabei (zumindest) Teil der Automatisierungsplattform sein, um die mehreren Funktionsmodule daran anzuschließen und/oder miteinander zu verbinden, und auf diese Weise modular verschiedene Funktionen für die Automatisierung wie die Ansteuerung der Motoren bereitzustellen. Dies kann den Vorteil haben, dass die Verbindungsvorrichtung mit den Funktionsmodulen in der Lage versetzt wird, eine Vielzahl von Geräten und Komponenten in einer elektrischen Anlage zu verbinden und/oder zu steuern und/oder auszuwerten, um eine reibungslose und effiziente Automatisierung zu gewährleisten.

Die Automatisierungsplattform kann dadurch dezentral ausgebildet sein, dass sie mit einer oder mehreren weiteren dezentralen Automatisierungsplattformen Automatisierungsfunktionen für die Anlage bereitstellt. Dabei können die eine oder mehreren weiteren dezentralen Automatisierungsplattformen jeweils ebenfalls als erfindungsgemäße Automatisierungsplattform ausgebildet sein. Die Automatisierungsplattformen können entsprechend Teilautomatisierungsfunktionen bereitstellen, welche komplementär die Automatisierung der Anlage ermöglichen. Die Teilautomatisierungsfunktionen umfassen bspw. eine Steuerung und/oder Regelung von Größen wie Druck, Durchfluss oder Temperatur und/oder eine Überwachung von Prozessparametern und/oder eine Steuerung und/oder Auswertung von Aktoren und Sensoren.

Es kann vorgesehen sein, dass die einzelnen unterschiedlichen Teilautomatisierungsfunktionen durch dafür ausgebildete Funktionsmodule bereitgestellt werden. Auf diese Weise können Teilautomatisierungsfunktionen bei einer Automatisierungsplattform modular ergänzt und kombiniert werden. Die Funktionsmodule umfassen bspw. ein Energieversorgungsmodul, wie ein Netzteil, und/oder ein Feldbusmodul und/oder ein Sicherheitsmodul zur Überwachung und Absicherung von Prozessen und/oder ein Motorsteuerungsmodul und/oder einen Industrie-PC, welcher Steuerungsaufgaben übernehmen kann. Zusätzlich können auch Pneumatik- und/oder Hydraulikmodule als Funktionsmodule vorgesehen sein, um bspw. Bewegungen und Kräfte zu steuern. Diese Module können beispielsweise dazu ausgebildet sein, Zylinder, Ventile und/oder Pumpen anzusteuern Auch können diese Funktionsmodule Zylinder, Ventile und/oder Pumpen umfassen. Durch die Kombination von elektronischen und pneumatischen/hydraulischen Elementen können komplexe und präzise Steuerungsaufgaben in verschiedenen Anwendungsbereichen, wie der Automatisierungstechnik, realisiert werden.

Ferner ist es denkbar, dass die Automatisierungsplattformen mit einer übergeordneten Steuerung (Zentralsteuerung) verbunden sind, bspw. über ein Feldbussystem. Allerdings können die dezentralen Automatisierungsplattformen eine Funktion eines zentralen Schaltschrankes ggf. zumindest teilweise ersetzen. Hierzu können die Automatisierungsplattform im Feld der Anlage angeordnet sein, z. B. in der Nähe von Aktoren und Sensoren. Dies kann den Vorteil haben, dass eine hohe Flexibilität und Skalierbarkeit der Automatisierung erreicht wird, da weitere dezentrale Automatisierungsplattformen in einfacher Weise hinzugefügt werden können, um zusätzliche Automatisierungsfunktionen bereitzustellen. Es ist außerdem möglich, dass durch die dezentrale Ausbildung der Automatisierungsplattformen eine einfachere Wartung, eine höhere Robustheit und Ausfallsicherheit der Automatisierung erreicht wird, da Ausfälle einzelner Komponenten durch andere dezentrale Automatisierungsplattformen kompensiert werden können. Dadurch wird eine hohe Verfügbarkeit der Automatisierung gewährleistet.

Ebenfalls unter Schutz gestellt sein kann eine Anlage mit den dezentralen Automatisierungsplattformen.

Die Modularität kann dadurch erreicht werden, dass die Funktionsmodule als einzelne, insbesondere voneinander unabhängige Module ausgebildet sind, jeweils mit einem eigenen Modulgehäuse und einer Elektronik, die es erlaubt, die Module individuell zu konfigurieren und mit weiteren Funktionsmodulen funktional zu kombinieren. Auch können die Funktionsmodule Daten- und/oder Energieversorgungs-Schnittstellen zueinander und/oder zu Geräten und/oder Komponenten der elektrischen Anlage aufweisen. Es ist bspw. möglich, dass wenigstens eines der an der Verbindungsvorrichtung angeschlossenen Funktionsmodule in der Lage ist, eine kabelgebundene und/oder drahtlose Verbindung zu einem zu steuernden Gerät und/oder einer Komponente herzustellen. Auch kann wenigstens eines der an der Verbindungsvorrichtung angeschlossenen Funktionsmodule dazu ausgeführt sein, eine Energieversorgung für ein zu steuerndes Gerät und/oder einer Komponente und/oder der weiteren angeschlossenen Funktionsmodule bereitzustellen.

Bei der erfindungsgemäßen Verbindungsvorrichtung können ferner mehrere oder genau eine Hauptanschlussfläche vorgesehen sein, an welcher zumindest die Hauptanschlüsse angeordnet sind. Dies bedeutet insbesondere, dass die Hauptanschlüsse im Wesentlichen auf einer Ebene (Hauptebene) angeordnet sind. Die Fläche kann bspw. durch eine Gehäusewand der Verbindungsvorrichtung bereitgestellt werden.

Ferner kann optional wenigstens eine oder genau eine Führungsfläche vorgesehen sein, die in einem definierten Winkel (W1) zur jeweiligen Hauptanschlussfläche angeordnet ist, um die Funktionsmodule in den Anschlussbereich der Verbindungsvorrichtung mechanisch zu führen und damit eine Montage der Funktionsmodule zu unterstützen. Dabei kann die Montage zum Anschluss (der Funktionsmodule) an die Haupt- und/oder Nebenanschlüsse vorgesehen sein und hierzu wenigstens eine manuelle Montagehandlung wie ein Einbringen der Funktionsmodule in den Anschlussbereich und/oder ein Befestigen der Funktionsmodule umfassen. Die Führungsfläche kann ebenfalls durch eine Gehäusewand der Verbindungsvorrichtung bereitgestellt werden. Insbesondere sind dabei die Nebenanschlüsse im Wesentlichen auf einer Ebene angeordnet, die in dem definierten Winkel W1 zur Hauptebene steht bzw. geneigt ist und/oder parallel zu einer Ebene der Führungsfläche verläuft.

Außerdem kann optional ein Grundkörper mit einem Grundkörpergehäuse und/oder mit einer Verbindungsanordnung bei der erfindungsgemäßen Verbindungsvorrichtung vorgesehen sein. Dabei kann die Verbindungsanordnung mit den Haupt- und/oder Nebenanschlüssen elektrisch verbunden sein, um vorzugsweise (zumindest teilweise) eine elektrische Verbindung für zumindest einen Teil der angeschlossenen Funktionsmodule untereinander bereitzustellen. Die Verbindungsanordnung kann zumindest teilweise als eine innere Verkabelung und/oder innere Verdrahtung und/oder innere Leiterbahnenanordnung (z. B. durch Leiterbahnen wenigstens einer Leiterplatte) der Verbindungsvorrichtung ausgeführt sein. "Innen" kann sich dabei auf die Anordnung der Verbindungsanordnung innerhalb des Grundkörpergehäuses und/oder weiterer Gehäuseelemente der Verbindungsvorrichtung beziehen.

Die Gehäuseelemente der Verbindungsvorrichtung wie das Grundkörpergehäuse und Gehäusewände können aus Kunststoff hergestellt sein, insbesondere einem nicht-leitenden Kunststoff. Die Verbindungsanordnung kann teilweise oder überwiegend oder vollständig im Inneren des Grundkörpergehäuses angeordnet sein.

Ferner ist es möglich, dass optional elektrische Leitungen der Verbindungsanordnung vorgesehen sind, die (teilweise oder überwiegend oder vollständig) im Grundkörpergehäuse angeordnet sein können, um einen Hauptenergiefluss und/oder einen Hilfsenergiefluss und/oder einen Datenfluss für die angeschlossenen Funktionsmodule bereitzustellen. Auf diese Weise kann die Automatisierungsplattform zuverlässig zur Ansteuerung von elektrischen Geräten einer industriellen Anlage betrieben werden. Die elektrischen Leitungen können z. B. als Kabel, gedruckte Leiterbahnen, flexible Leiterplatten oder Schaltkreise ausgeführt sein.

Es kann im Rahmen der Erfindung vorgesehen sein, dass die Hauptanschlüsse beabstandet voneinander angeordnet sind, um jeweils eines der Funktionsmodule in einer vordefinierten Position aufzunehmen und zu halten. Bspw. können die Hauptanschlüsse in einer Richtung (Breitenrichtung) der Verbindungsanordnung angeordnet sein, um die Funktionsmodule in dieser Richtung angereiht und damit nebeneinander aufzunehmen. Der Abstand der Hauptanschlüsse in dieser Richtung kann mindestens der Breite der Funktionsmodule, d. h. der räumlichen Erstreckung der Funktionsmodule in dieser Richtung, entsprechen.

Weiter ist denkbar, dass die Hauptanschlüsse jeweils zumindest einen oder zumindest zwei der folgenden Verbindungselemente aufweisen:
- ein Hauptenergieverbindungselement zur Bereitstellung des Hauptenergieflusses für das daran angeschlossene Funktionsmodul, insbesondere zur elektrischen Energieversorgung von "ersten" elektrischen Geräten der Anlage, vorzugsweise für Motoren,
- ein Hilfsenergieverbindungselement zur Bereitstellung des Hilfsenergieflusses für das daran angeschlossene Funktionsmodul, insbesondere mit geringerer elektrischer Spannung und/oder geringerem elektrischen Strom als der Hauptenergiefluss, vorzugsweise zur elektrischen Energieversorgung einer Elektronik (z. B. des daran angeschlossenen Funktionsmoduls) und/oder von Geräten und/oder Komponenten der Anlage, die einen geringeren Energieverbrauch als die ersten elektrischen Geräte haben,
- ein Datenverbindungselement zur Bereitstellung des Datenflusses für das daran angeschlossene Funktionsmodul.

Die Hauptanschlüsse können mit anderen Worten jeweils zumindest oder genau zwei Verbindungselemente, insbesondere in der Form von elektrischen Anschlusselementen, aufweisen. Auch können ggf. die Nebenanschlüsse jeweils zumindest oder genau ein Verbindungselement, insbesondere in der Form eines elektrischen Anschlusselements, aufweisen.

Unter Bereitstellen eines Hauptenergie-, Hilfsenergie-, und/oder Datenflusses wird insbesondere verstanden, dass das angeschlossene Funktionsmodul den entsprechenden Energie- oder Datenfluss abgreifen kann, aber nicht muss (nicht zwingend muss das Funktionsmodul z. B. das Hauptenergieverbindungselement kontaktieren, wenn es den Hauptenergiefluss nicht benötigt).

Das Hauptenergieverbindungselement, das Hilfsenergieverbindungselement und das Datenverbindungselement können unterschiedlich ausgebildet sein. Bspw. können sich die Verbindungselemente hinsichtlich ihrer Geometrie und/oder Form und/oder Fläche und/oder Länge und/oder Kodierung und/oder elektrischen Eigenschaften und/oder der Anzahl ihrer Kontakte unterscheiden. Die Kodierung ist insbesondere eine Kodierung für eine Verbindung und vorzugsweise Steckverbindung. Damit ist gemeint, dass die Kodierung dazu dient, die richtige Positionierung und Ausrichtung der Verbindung sicherzustellen und eine fehlerhafte Verbindung zu verhindern. Hierzu kann die Kodierung beispielsweise eine bestimmte Form aufweisen, die nur eine bestimmte Ausrichtung der Verbindung zulässt. Alternativ kann die Kodierung auch durch eine spezielle Farbcodierung oder durch eine spezielle Anordnung der Kontakte realisiert werden.

Die Verbindungselemente können gemäß wenigstens einer der folgenden Anschlusstypen ausgebildet sein: Steckverbindungsanschluss, Socket, bspw. Stecksockel, Schraubanschluss, Federklammer-Verbindung, Leiterplattenkontakt. Dabei kann sich der Anschlusstyp der Verbindungselemente der Hauptanschlüsse von dem oder denen der Nebenanschlüsse unterscheiden. Auch können die Verbindungselemente der Hauptanschlüsse gemäß einem gleichen oder alternativ unterschiedlichen Anschlusstyp ausgebildet sein.

Von weiterem Vorteil kann vorgesehen sein, dass die Hauptanschlüsse jeweils das Hilfsenergieverbindungselement und das Datenverbindungselement aufweisen, wobei die Nebenanschlüsse jeweils das Hauptenergieverbindungselement aufweisen können. Mit anderen Worten können die Hauptanschlüsse jeweils als eine Anordnung ausgebildet sein, bei welcher die zwei Verbindungselemente (Hilfs- und Datenverbindungselement) bei jedem der Hauptanschlüsse vorgesehen sind. Die elektrischen Leitungen der Verbindungsanordnung sind dabei vorzugsweise innerhalb des Grundkörpergehäuses teilweise mit den Nebenanschlüssen und teilweise mit den Hauptanschlüssen elektrisch verbunden.

Gemäß einer vorteilhaften Weiterbildung der Erfindung kann vorgesehen sein, dass die Verbindungsvorrichtung ferner aufweist: mehrere oder genau eine Nebenanschlussfläche, die in einem weiteren definierten Winkel zur jeweiligen Hauptanschlussfläche angeordnet ist, und an welcher die Nebenanschlüsse angeordnet sind. Mit anderen Worten können die Nebenanschlüsse einen Anschluss der Funktionsmodule in einer anderen Achse und/oder von einer anderen Richtung aus und/oder mit einer anderen Gehäuseseite der Funktionsmodule ermöglichen als die Hauptanschlüsse. Dies kann den Vorteil haben, dass eine flexiblere Anordnung der Funktionsmodule innerhalb der Verbindungsvorrichtung möglich ist. Durch die Verwendung der Nebenanschlüsse in einem anderen Winkel als die Hauptanschlüsse können die Funktionsmodule auch in engen oder unzugänglichen Bereichen platziert werden, ohne dass die Verbindung zu anderen Modulen beeinträchtigt wird.

Vorteilhafterweise kann im Rahmen der Erfindung vorgesehen sein, dass die Nebenanschlüsse an der wenigstens einen Führungsfläche angeordnet sind. Es ist damit möglich, dass die Montage vereinfacht und sicherer wird, da eine mechanische Führung der Funktionsmodule die Montagebewegung unterstützen kann.

Außerdem ist es von Vorteil, wenn die Nebenanschlüsse in Relation zu den Hauptanschlüssen unterschiedlich ausgerichtet sind, insbesondere mit einem unterschiedlichen Winkle, so dass bei der Montage eine mechanische und/oder elektrische Kontaktierung zwischen dem Funktionsmodul und den Haupt- und Nebenanschlüssen aus unterschiedlichen Richtungen erfolgt, vorzugsweise in mehr als einer Achse. Dabei kann die wenigstens eine Führungsfläche eine mechanische Führung in einer Einschubrichtung und/oder in einer Breitenrichtung bzw. Waagerechten der Verbindungsvorrichtung bereitstellen, um die Kontaktierung mit den Hauptanschlüssen in der Einschubrichtung zu unterstützen. Auch kann die Führungsfläche vorzugsweise eine Bewegung der Funktionsmodule bei der Montage in einer zur Einschubrichtung abweichenden Richtung begrenzen. Damit wird die Montage einfacher und weniger fehleranfällig.

Ferner kann im Rahmen der Erfindung vorgesehen sein, dass die elektrischen Leitungen der Verbindungsanordnung die nachfolgenden Leitungen umfassen:
- Hauptenergieleitungen, die dazu ausgebildet sind, den Hauptenergiefluss mit einer Wechselspannung bis zu 1000 Volt und/oder einer Gleichspannung bis zu 1500 Volt und/oder mit einer Wechselspannung im Bereich von 70 Volt bis 1000 Volt und/oder mit einer Gleichspannung im Bereich von 130 Volt bis 1500 Volt, und bevorzugt mit einer Wechselspannung von im Wesentlichen 400 Volt oder einer Gleichspannung im Bereich von 650 V bis 700 V, bereitzustellen, vorzugsweise, um wenigstens eines der elektrischen Geräte mit Energie zu versorgen,
- Hilfsenergieleitungen, die dazu ausgebildet sind, den Hilfsenergiefluss mit einer Wechselspannung bis zu 50 Volt und/oder einer Gleichspannung bis zu 120 Volt und/oder mit einer Wechselspannung im Bereich von 0,01 Volt bis 50 Volt und/oder mit einer Gleichspannung im Bereich von 0,01 Volt bis 120 Volt, und bevorzugt mit einer Gleichspannung von im Wesentlichen 24 V oder 48 V, bereitzustellen, vorzugsweise, um eine Energieversorgung für wenigstens eines der Funktionsmodule und/oder für eine Kommunikation mit wenigstens einem der elektrischen Geräte bereitzustellen, bevorzugt für einen Feldbus,
- Datenleitungen, die dazu ausgebildet sind, ein Daten- und vorzugsweise Feldbussignal zu übertragen, vorzugsweise zur Kommunikation mit wenigstens einem der elektrischen Geräte.

Die Hauptenergie-, Hilfsenergie- und Datenleitungen können sich z. B. hinsichtlich ihres Leitungsdurchmessers unterscheiden, um für unterschiedliche elektrische Leistungen geeignet zu sein. Die Hauptenergie- und Hilfsenergieleitungen können ggf. Litzenleiter umfassen, um eine höhere Flexibilität und Biegsamkeit zu gewährleisten.

Optional kann es vorgesehen sein, dass die Hauptenergieleitungen und die Hilfsenergieleitungen und/oder Datenleitungen in getrennten Kanälen des Grundkörpers angeordnet und bevorzugt durch eine Trennwand voneinander getrennt sind. Dies kann den Vorteil haben, dass eine bessere Abschirmung gegen elektromagnetische Störungen erreicht wird, da die Hauptenergieleitungen und die Hilfsenergieleitungen und/oder Datenleitungen getrennt voneinander verlaufen. Außerdem kann die Trennwand eine höhere Sicherheit gewährleisten, indem sie verhindert, dass im Falle eines Fehlers bei den Hauptenergieleitungen die Hilfsenergieleitungen und/oder Datenleitungen beschädigt werden. Darüber hinaus kann die Anordnung der Leitungen in getrennten Kanälen die Wartung und Reparatur erleichtern, da die betroffenen Leitungen leichter identifiziert und erreicht werden können.

Gemäß einem weiteren Vorteil kann vorgesehen sein, dass der definierte Winkel und vorzugsweise auch der weitere definierte Winkel im Wesentlichen 90 Grad betragen, wobei vorzugsweise die jeweilige Führungsfläche mit der einen oder mindestens einer der Hauptanschlussflächen verbunden ist und eine Verlängerung der jeweiligen Hauptanschlussfläche darstellen kann. Damit kann eine zuverlässige Führung ermöglicht und ein besonders stabiler Gehäuseaufbau bereitgestellt werden.

Vorteilhaft ist es zudem, wenn eine Kontaktierung zwischen einer Verbinderanordnung eines der Funktionsmodule, umfassend einen Funktionsmodulhauptverbinder und einen Funktionsmodulnebenverbinder, und einer Anschlussanordnung des Grundkörper, umfassend einen der Hauptanschlüsse und einen der Nebenanschlüsse, in mehr als einer Achse erfolgt. Dies kann den Vorteil haben, dass eine stabile und zuverlässige Verbindung zwischen den Funktionsmodulen und dem Grundkörper gewährleistet wird. Durch eine mehrachsige Kontaktierung wird außerdem eine höhere Flexibilität bei der Anordnung der Funktionsmodule auf dem Grundkörper ermöglicht. Es ist außerdem möglich, dass durch eine mehrachsige Kontaktierung eine höhere Anzahl von Funktionsmodulen auf dem Grundkörper untergebracht werden kann, was zu einer höheren Funktionalität des Gesamtsystems führt.

Gemäß einer vorteilhaften Weiterbildung der Erfindung kann vorgesehen sein, dass das Grundkörpergehäuse mehrteilig ausgebildet ist und die jeweilige Hauptanschlussfläche und Führungsfläche und insbesondere die Nebenanschlussfläche ausbildet. Alternativ oder zusätzlich kann das Grundkörpergehäuse im Wesentlichen L- oder U-förmig ausgebildet sein, wobei die Teile des Grundkörpergehäuses form- und/oder kraftschlüssig miteinander verbunden sein können. Auf diese Weise kann eine besonders stabile und leicht zu montierende Automatisierungsplattform bereitgestellt werden.

Es kann ferner möglich sein, dass das Grundkörpergehäuse einteilig ausgebildet ist und die jeweilige Hauptanschlussfläche und Führungsfläche und insbesondere die Nebenanschlussfläche ausbildet, wobei das Grundkörpergehäuse im Wesentlichen L- oder U-förmig ausgebildet ist. Dies ermöglicht einen besonders einfachen und stabilen Aufbau der Verbindungsvorrichtung.

Vorteilhafterweise kann bei der Erfindung vorgesehen sein, dass wenigstens ein Dichtmittel im Anschlussbereich vorgesehen ist, um den Anschlussbereich abzudichten. Durch die Verwendung eines geeigneten Dichtmittels kann somit eine verbesserte Funktionalität und Langlebigkeit der erfindungsgemäßen Vorrichtung erreicht werden. Es ist außerdem möglich, dass das Dichtmittel eine hohe Temperatur- und Chemikalienbeständigkeit aufweist, um den Anforderungen der jeweiligen Anwendung gerecht zu werden. Das Dichtmittel kann dazu geeignet sein, das Eindringen von Feuchtigkeit, Staub und Schmutz in die Verbindungsvorrichtung zu verhindern, um die Elektronik im Gehäuse der Verbindungsvorrichtung zu schützen. Ein Beispiel für ein solches Dichtmittel ist Silikondichtmasse, die aufgrund ihrer hohen Elastizität und Beständigkeit gegenüber Feuchtigkeit und UV-Strahlung besonders vorteilhaft ist. Ein weiteres Beispiel ist Polyurethan als Dichtmittel, das aufgrund seiner hohen chemischen Beständigkeit und seiner Fähigkeit, sich an unebene Oberflächen anzupassen, geeignet ist. Ein weiteres mögliches Dichtmittel ist Epoxidharz, das aufgrund seiner hohen Festigkeit, chemischen Beständigkeit und elektrischen Isolationseigenschaften geeignet ist. Darüber hinaus kann die Form des Dichtmittels an eine äußere Gehäuseform der Verbindungsvorrichtung und/oder der Funktionsmodule angepasst sein. So ist es möglich, dass das Dichtmittel nahtlos in die Gehäuseform integriert wird und somit eine glatte Oberfläche entsteht, die eine einfache Reinigung und Wartung ermöglicht.

Es kann weiter möglich sein, dass wenigstens eine Aufnahme für ein Befestigungselement, vorzugsweise für eine Schraube, vorgesehen ist. Die Aufnahme, vorzugsweise eine Gewindebohrung, kann mit einem Winkel, vorzugsweise im Bereich von 10 ° bis 80 °, zur Hauptanschlussfläche im Grundkörpergehäuse ausgebildet sein, um eine schräge Befestigung und vorzugsweise Verschraubung des jeweiligen Funktionsmoduls mit dem Grundkörpergehäuse bereitzustellen. Dies kann den Vorteil haben, dass das Funktionsmodul sicher und stabil befestigt ist. Es ist außerdem möglich, dass die Aufnahme für das Befestigungselement in einer Ausnehmung im Grundkörpergehäuse angeordnet ist, um eine flache und ebene Hauptanschlussfläche zu gewährleisten. Dadurch kann das Funktionsmodul bündig mit dem Grundkörpergehäuse und insbesondere der Anschlussfläche abschließen und eine kompakte Bauweise der Automatisierungsplattform ermöglicht werden.

Ebenfalls Gegenstand der Erfindung ist eine Automatisierungsplattform, aufweisend eine erfindungsgemäße Verbindungsvorrichtung sowie die mehreren Funktionsmodule. Damit bringt die erfindungsgemäße Automatisierungsplattform die gleichen Vorteile mit sich, wie sie ausführlich mit Bezug auf eine erfindungsgemäße Verbindungsvorrichtung beschrieben worden sind.

Ebenfalls Gegenstand der Erfindung kann optional ein System für eine industrielle Anlage und/oder eine industrielle Anlage sein, welche(s) zumindest zwei oder zumindest vier oder zumindest sechs Automatisierungsplattformen aufweist. Die jeweilige Automatisierungsplattform kann hierbei dadurch dezentral ausgebildet sein, dass sie mit der oder den jeweils anderen Automatisierungsplattformen gemeinsam Automatisierungsfunktionen und vorzugsweise Teilautomatisierungsfunktionen für die industrielle Anlage bereitstellt. Dabei können die jeweiligen Automatisierungsplattformen als erfindungsgemäße Automatisierungsplattform ausgebildet sein.

Die Automatisierungsplattformen können optional jeweils Teilautomatisierungsfunktionen bereitstellen, welche komplementär (also in Bezug auf die gemeinsame Bereitstellung der Teilautomatisierungsfunktionen durch die sämtlichen Automatisierungsplattformen) die Automatisierung der Anlage ermöglichen. Die Teilautomatisierungsfunktionen umfassen bspw. eine Steuerung und/oder Regelung von Größen wie Druck, Durchfluss oder Temperatur und/oder eine Überwachung von Prozessparametern und/oder eine Steuerung und/oder Auswertung von Aktoren und Sensoren.

Ebenfalls Gegenstand der Erfindung ist ein Verfahren zum Herstellen und/oder Betreiben einer, insbesondere erfindungsgemäßen, Verbindungsvorrichtung zur Bereitstellung einer dezentralen Automatisierungsplattform.

Das Verfahren kann gemäß einem ersten Schritt ein Bereitstellen einer Anordnung von mehreren Haupt- und Nebenanschlüssen umfassen, wobei die Haupt- und Nebenanschlüsse zum elektrischen Anschluss von mehreren Funktionsmodulen in einem Anschlussbereich der Verbindungsvorrichtung vorgesehen sein können.

Weiter kann das Verfahren gemäß einem weiteren Schritt umfassen: Bereitstellen von mehreren oder genau einer Hauptanschlussfläche, an welcher zumindest die Hauptanschlüsse angeordnet sind. Hierzu kann die Hauptanschlussfläche bspw. durch eine Gehäusewand bereitgestellt werden, welche Ausnehmungen aufweist, in denen entsprechende Hauptanschlüsse vorgesehen sind.

Weiter kann das Verfahren gemäß einem weiteren Schritt umfassen: Bereitstellen wenigstens einer Führungsfläche, die in einem definierten Winkel zur jeweiligen Hauptanschlussfläche angeordnet ist, um die Funktionsmodule in den Anschlussbereich mechanisch zu führen und damit eine Montage der Funktionsmodule zu unterstützen, die zum Anschluss an die Haupt- und/oder Nebenanschlüsse vorgesehen ist. Die Führungsfläche kann z. B. durch eine Gehäusewand bereitgestellt werden, die sich im definierten Winkel von der Gehäusewand erstreckt, die die Hauptanschlussfläche bildet. Die beiden Gehäusewände werden bspw. dadurch mit einem Winkel hergestellt, dass die Führungsfläche eine gewünschte Neigung aufweist. Hierzu kann ein Kunststoff z. B. durch Spritzgussverfahren in die gewünschte Form gebracht werden.

Weiter kann das Verfahren gemäß einem weiteren Schritt umfassen: Bereitstellen eines Grundkörpers mit einem Grundkörpergehäuse und mit einer Verbindungsanordnung, wobei die Verbindungsanordnung mit den Haupt- und Nebenanschlüssen elektrisch verbunden ist, um eine elektrische Verbindung der angeschlossenen Funktionsmodule untereinander bereitzustellen.

Weiter kann das Verfahren gemäß einem weiteren Schritt umfassen: Bereitstellen elektrischer Leitungen der Verbindungsanordnung, die im Grundkörpergehäuse angeordnet sind, um einen Hauptenergiefluss und/oder einen Hilfsenergiefluss und/oder einen Datenfluss für die angeschlossenen Funktionsmodule bereitzustellen, um die Automatisierungsplattform zur Ansteuerung von elektrischen Geräten einer industriellen Anlage zu betreiben.

Damit bringt das erfindungsgemäße Verfahren die gleichen Vorteile mit sich, wie sie ausführlich mit Bezug auf eine erfindungsgemäße Verbindungsvorrichtung beschrieben worden sind.

Ebenfalls Gegenstand der Erfindung ist ein Funktionsmodul zur Bereitstellung wenigstens einer Funktion für eine elektrische Anlage. Das Funktionsmodul kann dabei dazu ausgebildet sein, um mit einer erfindungsgemäßen Verbindungsvorrichtung eine dezentrale Automatisierungsplattform bereitzustellen, und insbesondere dazu ausgeführt sein, an der erfindungsgemäßen Verbindungsvorrichtung angeschlossen zu werden. Dabei kann das Funktionsmodul eine Verbinderanordnung umfassen, die einen Funktionsmodulhauptverbinder und/oder einen Funktionsmodulnebenverbinder aufweist, wobei der Funktionsmodulhauptverbinder zur Kontaktierung mit einem der Hauptanschlüsse der Verbindungsvorrichtung ausgebildet sein kann, und wobei der Funktionsmodulnebenverbinder zur Kontaktierung mit einem der Nebenanschlüsse der Verbindungsvorrichtung ausgebildet sein kann.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1: eine perspektivische Ansicht auf eine Verbindungsvorrichtung gemäß Ausführungsbeispielen der Erfindung.
- Fig. 2: eine schematische Darstellung einer Verbindungsanordnung.
- Fig. 3: eine weitere schematische Darstellung einer Verbindungsvorrichtung gemäß Ausführungsbeispielen der Erfindung.
- Fig. 4: eine weitere schematische Darstellung einer Verbindungsvorrichtung gemäß Ausführungsbeispielen der Erfindung.
- Fig. 5: eine weitere schematische Darstellung einer Verbindungsvorrichtung gemäß Ausführungsbeispielen der Erfindung.
- Fig. 6: eine Visualisierung eines Verfahrens gemäß Ausführungsbeispielen der Erfindung.

In den nachfolgenden Figuren werden für die gleichen technischen Merkmale auch von unterschiedlichen Ausführungsbeispielen die identischen Bezugszeichen verwendet.

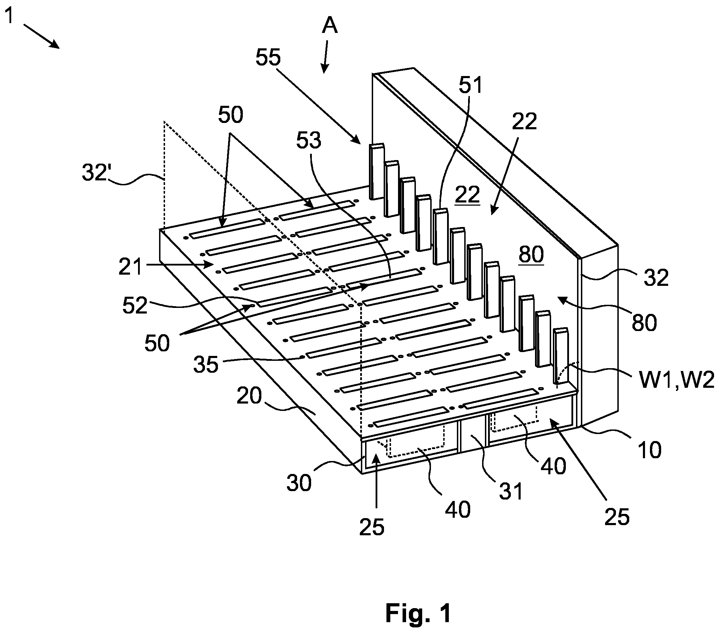

Fig. 1 veranschaulicht eine Verbindungsvorrichtung 10 gemäß Ausführungsbeispielen der Erfindung zur Bereitstellung einer dezentralen Automatisierungsplattform 1. Es ist eine Anordnung von mehreren Haupt- und Nebenanschlüssen 50,55 dargestellt, die zum elektrischen Anschluss von mehreren Funktionsmodulen 200 in einem Anschlussbereich A der Verbindungsvorrichtung 10 vorgesehen sind. Weiter ist eine Hauptanschlussfläche 21 gezeigt, an welcher zumindest die Hauptanschlüsse 50 angeordnet sind. Die Hauptanschlussfläche 21 wird vorliegend beispielhaft durch eine Gehäusewand gebildet, die ein Raster von mehreren Öffnungen für die Hauptanschlüsse 50 aufweist. Die Öffnungen können in der Gehäusewand z. B. dadurch ausgebildet werden, dass entsprechende Aussparungen in das Material gefräst oder gestanzt werden. Alternativ können die Öffnungen auch durch den Einsatz von Lasertechnologie in das Gehäuse geschnitten werden. Unterhalb der Gehäusewand kann eine Elektronik vorgesehen sein, insbesondere wenigstens eine Leiterplatte und/oder die Hauptanschlüsse 50 in der Form von elektrischen Steckverbindungen. Die Hauptanschlüsse 50 können optional durch die Öffnungen herausragen.

Es ist außerdem eine erste Führungsfläche 80 einer ersten Führungswand 32 und eine weitere optionale Führungsfläche (gestrichelte Linie) einer zweiten Führungswand 32' dargestellt, die jeweils in einem definierten Winkel W1 zur jeweiligen Hauptanschlussfläche 21 angeordnet sind. Dies ermöglicht es, dass die Funktionsmodule 200 in den Anschlussbereich A mechanisch geführt werden und damit eine Montage der Funktionsmodule 200 unterstützt wird, die zum Anschluss an die Haupt- und/oder Nebenanschlüsse 50,55 vorgesehen ist. Weiter ist ein Grundkörper 20 mit einem Grundkörpergehäuse 30 dargestellt. Bei der Verwendung von nur einer ersten Führungsfläche 80 kann das Grundkörpergehäuse 30 eine L-Form und bei gegenüberliegend angeordneten Führungsflächen 32,32' eine U-Form ausbilden.

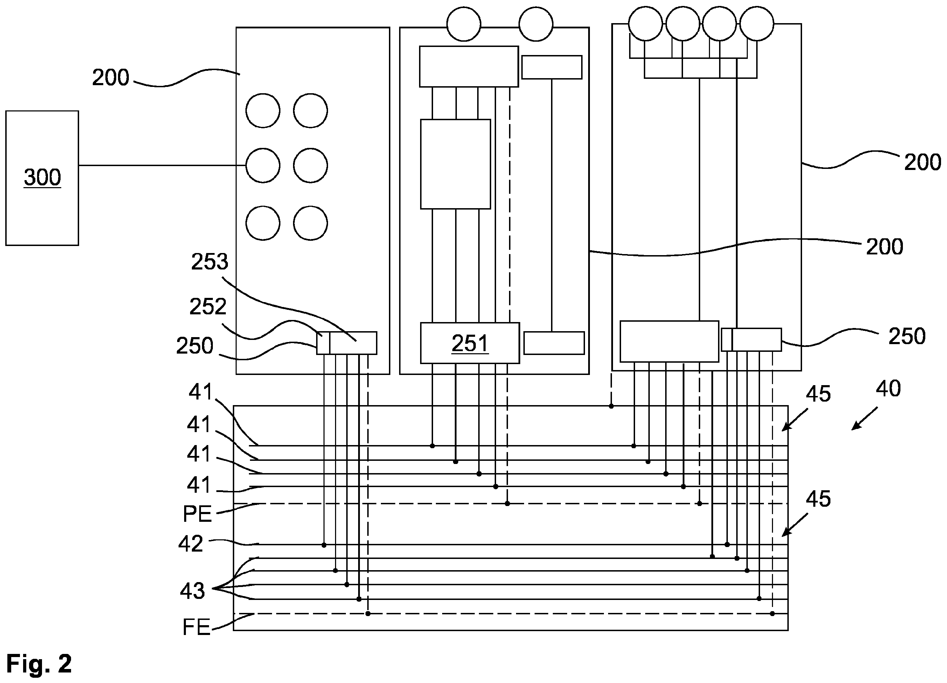

Innerhalb des Grundkörpergehäuses 30 kann eine Verbindungsanordnung 40 angeordnet sein, die mit den Haupt- und Nebenanschlüssen 50,55 elektrisch verbunden ist. Die in Fig. 2 schematisch dargestellten elektrischen Leitungen 45 der Verbindungsanordnung 40 können im Grundkörpergehäuse 30 nach außen hin elektrisch isoliert untergebracht sein. Sie dienen dazu, einen Hauptenergiefluss und/oder einen Hilfsenergiefluss und/oder einen Datenfluss für die angeschlossenen Funktionsmodule 200 bereitzustellen, um auf diese Weise die Automatisierungsplattform 1 zur Ansteuerung von elektrischen Geräten 300 einer industriellen Anlage zu betreiben.

Wie in Fig. 1 deutlich erkennbar ist, können die Hauptanschlüsse 50 in einem Raster in gleichen Abständen beabstandet voneinander angeordnet sein, um jeweils eines der Funktionsmodule 200 in einer vordefinierten Position aufzunehmen und zu halten. Abweichend davon ist es auch möglich, dass die Hauptanschlüsse 50 in unregelmäßigen Abständen angeordnet sind. Dabei können die Hauptanschlüsse 50 jeweils zumindest zwei der folgenden Verbindungselemente 51,52,53 aufweisen: ein Hauptenergieverbindungselement 51 zur Bereitstellung des Hauptenergieflusses für das daran angeschlossene Funktionsmodul 200, ein Hilfsenergieverbindungselement 52 zur Bereitstellung des Hilfsenergieflusses für das daran angeschlossene Funktionsmodul 200, mit geringerer elektrischer Spannung als der Hauptenergiefluss, ein Datenverbindungselement 53 zur Bereitstellung des Datenflusses für das daran angeschlossene Funktionsmodul 200. Bevorzugt ist es, dass die Hauptanschlüsse 50 jeweils das Hilfsenergieverbindungselement 52 und das Datenverbindungselement 53 aufweisen, wobei die Nebenanschlüsse 55 jeweils das Hauptenergieverbindungselement 51 aufweisen. Dabei können die elektrischen Leitungen 45 der Verbindungsanordnung 40 innerhalb des Grundkörpergehäuses 30 teilweise mit den Nebenanschlüssen 55 und teilweise mit den Hauptanschlüssen 50 elektrisch verbunden sein.

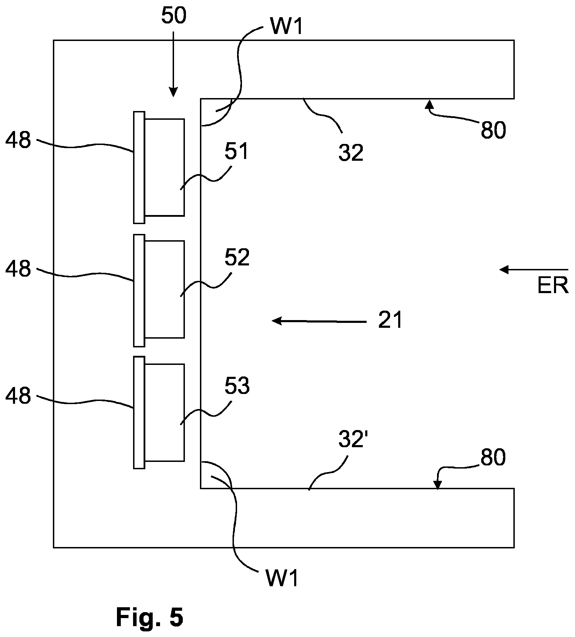

Die Verbindungsvorrichtung 10 kann wie in Fig. 1 sowie Fig. 3 und 4 gezeigt mehrere oder genau eine Nebenanschlussfläche 22 aufweisen, die in einem weiteren definierten Winkel W2 zur jeweiligen Hauptanschlussfläche 21 angeordnet ist, und an welcher die Nebenanschlüsse 55 angeordnet sind. Gemäß Fig. 1 bis 4 ist es möglich, dass die Nebenanschlüsse 55 an der wenigstens einen Führungsfläche 80 angeordnet sind. In Fig. 5 sind die Nebenanschlüsse 55 hingegen ebenfalls an der Hauptanschlussfläche 21 vorgesehen.

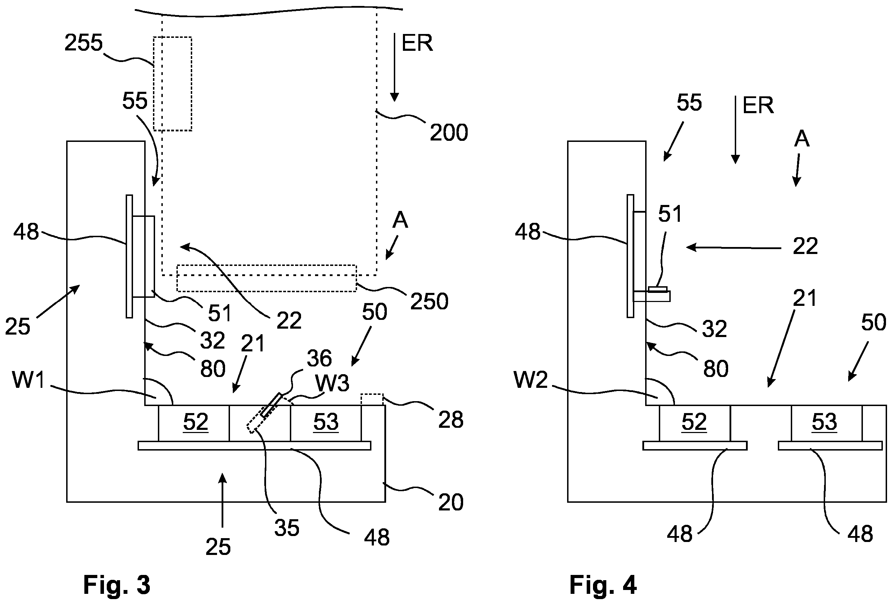

Die Nebenanschlüsse 55 können in Relation zu den Hauptanschlüssen 50 unterschiedlich ausgerichtet sein (s. Fig. 3), so dass bei der Montage eine mechanische und/oder elektrische Kontaktierung zwischen dem Funktionsmodul 200 und den Haupt- und Nebenanschlüssen 55 aus unterschiedlichen Richtungen erfolgt, vorzugsweise in mehr als einer Achse. Dabei kann die wenigstens eine Führungsfläche 80 eine mechanische Führung in einer Einschubrichtung ER und/oder in einer Waagerechten (senkrecht zur Richtung ER) der Verbindungsvorrichtung 10 bereitstellen, um die Kontaktierung mit den Hauptanschlüssen 50 in der Einschubrichtung ER zu unterstützen. Weiter kann die Führungsfläche 80 vorzugsweise eine Bewegung der Funktionsmodule 200 bei der Montage in einer zur Einschubrichtung ER abweichenden Richtung begrenzen. Dies kann den Vorteil haben, dass die Montage der Funktionsmodule 200 vereinfacht wird und eine fehlerhafte Montage vermieden wird. Es ist außerdem möglich, dass durch die Begrenzung der Bewegung der Funktionsmodule 200 eine höhere Präzision bei der Montage erreicht wird.

Gemäß Fig. 2 können die elektrischen Leitungen 45 der Verbindungsanordnung 40 die nachfolgenden Leitungen 45 umfassen: a) Hauptenergieleitungen 41, die dazu ausgebildet sind, den Hauptenergiefluss mit einer Wechselspannung bis zu 1000 Volt und/oder einer Gleichspannung bis zu 1500 Volt und/oder mit einer Wechselspannung im Bereich von 70 Volt bis 1000 Volt und/oder mit einer Gleichspannung im Bereich von 130 Volt bis 1500 Volt, und bevorzugt mit einer Wechselspannung von im Wesentlichen 400 Volt oder einer Gleichspannung im Bereich von 650 V bis 700 V, bereitzustellen, vorzugsweise, um wenigstens eines der elektrischen Geräte 300 mit Energie zu versorgen. b) Hilfsenergieleitungen 42, die dazu ausgebildet sind, den Hilfsenergiefluss mit einer Wechselspannung bis zu 50 Volt und/oder einer Gleichspannung bis zu 120 Volt und/oder mit einer Wechselspannung im Bereich von 0,01 Volt bis 50 Volt und/oder mit einer Gleichspannung im Bereich von 0,01 Volt bis 120 Volt, und bevorzugt mit einer Gleichspannung von im Wesentlichen 24 V oder 48 V, bereitzustellen, vorzugsweise, um eine Energieversorgung für wenigstens eines der Funktionsmodule 200 und/oder für eine Kommunikation mit wenigstens einem der elektrischen Geräte 300 bereitzustellen, bevorzugt für einen Feldbus. c) Datenleitungen 43, die dazu ausgebildet sind, ein Daten- und vorzugsweise Feldbussignal zu übertragen, vorzugsweise zur Kommunikation mit wenigstens einem der elektrischen Geräte 300.

In Fig. 2 sind ferner Funktionsmodulhauptenergieverbinder 251, Funktionsmodulhilfsenergieverbinder 252 und Funktionsmoduldatenverbinder 253 der Funktionsmodule 200 dargestellt. Dabei dienen die Verbinder 251,252,253 dazu, mit den entsprechenden Verbindungselementen 51,52,53 der Hauptanschlüsse 50 und Nebenanschlüsse 55 elektrisch verbunden zu werden, um den entsprechenden Haupt- und/oder Hilfsenergiefluss und/oder Datenfluss abzugreifen. Die Funktionsmodule 200 können dabei jeweils nur die Verbinder 251,252,253 aufweisen, wenn sie den entsprechenden Energie- und/oder Datenfluss tatsächlich benötigen.

Gemäß Fig. 1, 3 und 4 können die Hauptenergieleitungen 41 und/oder die Hilfsenergieleitungen 42 und/oder Datenleitungen 43 in getrennten Kanälen 25 des Grundkörpers 20 angeordnet und bevorzugt durch eine Trennwand 31 voneinander getrennt sein. Dies kann den Vorteil haben, dass die Leitungen vor äußeren Einflüssen geschützt werden, was die Stabilität und Zuverlässigkeit des Systems erhöht. Es ist außerdem möglich, dass durch die getrennte Anordnung der Leitungen eine einfachere Wartung und Reparatur des Systems ermöglicht wird, da die Leitungen leichter zugänglich sind. Die Trennwand 31 kann aus einem isolierenden Material hergestellt sein, um eine Interferenz zwischen den Leitungen zu vermeiden.

In Fig. 1 sowie 3 bis 5 ist dargestellt, dass der definierte Winkel W1 und vorzugsweise auch der weitere definierte Winkel W2 im Wesentlichen 90 Grad betragen kann, wobei die jeweilige Führungsflächen 80 mit der einen oder mindestens einer der Hauptanschlussflächen 21 verbunden ist und eine Verlängerung der jeweiligen Hauptanschlussfläche 21 darstellt. Weitere mögliche Bereiche für den Winkel W1 sind 80 bis 100 Grad und für den Winkel W2 sind 80 bis 110 Grad. Durch die feste Verbindung der Führungsflächen 80 mit den Hauptanschlussflächen 21 kann zudem eine besonders robuste und langlebige Verbindung geschaffen.

Aus Fig. 3 und 4 wird deutlich, dass eine Kontaktierung zwischen einer Verbinderanordnung 250,255 eines der Funktionsmodule 200, umfassend einen Funktionsmodulhauptverbinder 250 und einen Funktionsmodulnebenverbinder 255, und einer Anschlussanordnung 50,55 des Grundkörper 20, umfassend einen der Hauptanschlüsse 50 und einen der Nebenanschlüsse 55, in mehr als einer Achse erfolgen kann. Weiter ist erkennbar, dass das Grundkörpergehäuse 30 gemäß Ausführungsvarianten der Erfindung die jeweilige Hauptanschlussfläche 21 und Führungsfläche 80 und insbesondere die Nebenanschlussfläche 22 ausbildet. Dabei kann das Grundkörpergehäuse 30 im Wesentlichen L-förmig (s. Fig. 1, 3 und 4) oder U-förmig (s. Fig. 1 und 5) ausgebildet sein, wobei die Teile des Grundkörpergehäuses 30 form- und/oder kraftschlüssig miteinander verbunden sind.

In der Schnittdarstellung in Fig 3 ist schematisch wenigstens ein Dichtmittel 28 im Anschlussbereich A gezeigt, um den Anschlussbereich A abzudichten. Ebenfalls ist dargestellt, dass wenigstens eine Aufnahme 35 für ein Befestigungselement 36, vorzugsweise für eine Schraube, vorgesehen sein kann, wobei die Aufnahme 35, vorzugsweise eine Gewindebohrung, mit einem Winkel W3, vorzugsweise im Bereich von 10° bis 80°, zur Hauptanschlussfläche 21 im Grundkörpergehäuse 30 ausgebildet ist, um eine schräge Befestigung und vorzugsweise Verschraubung des jeweiligen Funktionsmoduls 200 mit dem Grundkörpergehäuse 30 bereitzustellen.

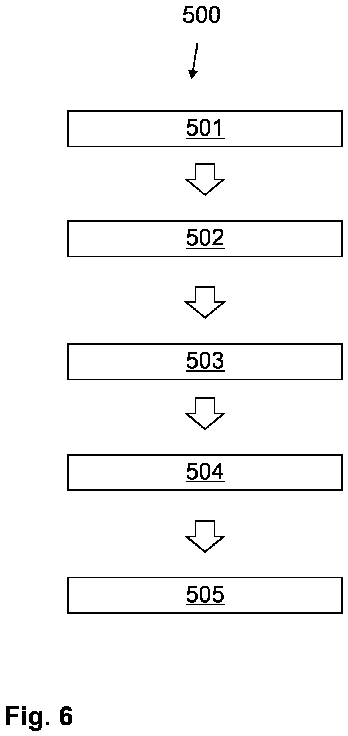

In Fig. 6 ist ein Verfahren 500 zum Betreiben einer Verbindungsvorrichtung 10 zur Bereitstellung einer dezentralen Automatisierungsplattform 1 schematisch visualisiert. Gemäß einem ersten Verfahrensschritt 501 erfolgt dabei ein Bereitstellen einer Anordnung von mehreren Haupt- und Nebenanschlüssen 50,55, die zum elektrischen Anschluss von mehreren Funktionsmodulen 200 in einem Anschlussbereich A der Verbindungsvorrichtung 10 vorgesehen sind. Gemäß einem zweiten Verfahrensschritt 502 erfolgt ein Bereitstellen von mehreren oder genau einer Hauptanschlussfläche 21, an welcher zumindest die Hauptanschlüsse 50 angeordnet sind. Gemäß einem dritten Verfahrensschritt 503 erfolgt ein Bereitstellen wenigstens einer Führungsfläche 80, die in einem definierten Winkel W1 zur jeweiligen Hauptanschlussfläche 21 angeordnet ist, um die Funktionsmodule 200 in den Anschlussbereich A mechanisch zu führen und damit eine Montage der Funktionsmodule 200 zu unterstützen, die zum Anschluss an die Haupt- und/oder Nebenanschlüsse 50,55 vorgesehen ist. Die Montage kann z. B. dadurch erfolgen, dass die Funktionsmodule 200 auf die Führungsfläche 80 aufgesetzt und dann in Richtung der Hauptanschlussfläche 21 manuell verschoben werden, bis sie in den Anschlussbereich A passen. Gemäß einem vierten Verfahrensschritt 504 erfolgt ein Bereitstellen eines Grundkörpers 20 mit einem Grundkörpergehäuse 30 und mit einer Verbindungsanordnung 40, wobei die Verbindungsanordnung 40 mit den Haupt- und Nebenanschlüssen 50,55 elektrisch verbunden ist, um eine elektrische Verbindung der angeschlossenen Funktionsmodule 200 untereinander bereitzustellen. Gemäß einem fünften Verfahrensschritt 505 erfolgt ein Bereitstellen elektrischer Leitungen 45 der Verbindungsanordnung 40, die im Grundkörpergehäuse 30 angeordnet sind, um einen Hauptenergiefluss, einen Hilfsenergiefluss und einen Datenfluss für die angeschlossenen Funktionsmodule 200 bereitzustellen, um die Automatisierungsplattform 1 zur Ansteuerung von elektrischen Geräten 300 einer industriellen Anlage zu betreiben.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 1: Automatisierungsplattform
- 10: Verbindungsvorrichtung
- 20: Grundkörper
- 21: Hauptanschlussfläche
- 22: Nebenanschlussfläche
- 25: Kanäle
- 28: Dichtmittel
- 30: Grundkörpergehäuse
- 31: Trennwand
- 32: Führungswand
- 35: Aufnahme
- 36: Befestigungselement
- 40: Verbindungsanordnung
- 41: Hauptenergieleitungen
- 42: Hilfsenergieleitungen
- 43: Datenleitungen
- 45: Leitungen
- 48: Leiterplatte
- 50: Hauptanschlüsse
- 51: Hauptenergieverbindungselement
- 52: Hilfsenergieverbindungselement
- 53: Datenverbindungselement
- 55: Nebenanschlüsse
- 80: Führungsfläche

- 200: Funktionsmodule
- 250: Funktionsmodulhauptverbinder
- 251: Funktionsmodulhauptenergieverbinder
- 252: Funktionsmodulhilfsenergieverbinder
- 253: Funktionsmoduldatenverbinder
- 255: Funktionsmodulnebenverbinder
- 300: elektrische Geräten
- 32': zweite Führungswand
- 500: Verfahren
- A: Anschlussbereich
- ER: Einschubrichtung
- W1: Winkel
- W2: weiteren definierten Winkel
- W3: weiterer Winkel

## Patentansprüche

1. Verbindungsvorrichtung (10) zur Bereitstellung einer dezentralen Automatisierungsplattform (1), aufweisend:
- eine Anordnung von mehreren Haupt- und Nebenanschlüssen (50,55), die zum elektrischen Anschluss von mehreren Funktionsmodulen (200) in einem Anschlussbereich (A) der Verbindungsvorrichtung (10) vorgesehen sind,
- mehrere oder genau eine Hauptanschlussfläche (21), an welcher zumindest die Hauptanschlüsse (50) angeordnet sind,
- wenigstens eine Führungsfläche (80), die in einem definierten Winkel (W1) zur jeweiligen Hauptanschlussfläche (21) angeordnet ist, um die Funktionsmodule (200) in den Anschlussbereich (A) mechanisch zu führen und damit eine Montage der Funktionsmodule (200) zu unterstützen, die zum Anschluss an die Haupt- und/oder Nebenanschlüsse (50,55) vorgesehen ist,
- einen Grundkörper (20) mit einem Grundkörpergehäuse (30) und mit einer Verbindungsanordnung (40), wobei die Verbindungsanordnung (40) mit den Haupt- und/oder Nebenanschlüssen (50,55) elektrisch verbunden ist, um eine elektrische Verbindung für zumindest einen Teil der angeschlossenen Funktionsmodule (200) untereinander bereitzustellen,
- elektrische Leitungen (45) der Verbindungsanordnung (40), die im Grundkörpergehäuse (30) angeordnet sind, um einen Hauptenergiefluss, einen Hilfsenergiefluss und einen Datenfluss für die angeschlossenen Funktionsmodule (200) bereitzustellen, um die Automatisierungsplattform (1) zur Ansteuerung von elektrischen Geräten (300) einer industriellen Anlage zu betreiben.

2. Verbindungsvorrichtung (10) nach Anspruch 1,
**dadurch gekennzeichnet,**
**dass** die Hauptanschlüsse (50) beabstandet voneinander angeordnet sind, um jeweils eines der Funktionsmodule (200) in einer vordefinierten Position aufzunehmen und zu halten, wobei die Hauptanschlüsse (50) jeweils zumindest zwei der folgenden Verbindungselemente (51,52,53) aufweisen:
- ein Hauptenergieverbindungselement (51) zur Bereitstellung des Hauptenergieflusses für das daran angeschlossene Funktionsmodul (200),
- ein Hilfsenergieverbindungselement (52) zur Bereitstellung des Hilfsenergieflusses für das daran angeschlossene Funktionsmodul (200), mit geringerer elektrischer Spannung als der Hauptenergiefluss,
- ein Datenverbindungselement (53) zur Bereitstellung des Datenflusses für das daran angeschlossene Funktionsmodul (200).

3. Verbindungsvorrichtung (10) nach Anspruch 2,
**dadurch gekennzeichnet,**
**dass** die Hauptanschlüsse (50) jeweils das Hilfsenergieverbindungselement (52) und das Datenverbindungselement (53) aufweisen, wobei die Nebenanschlüsse (55) jeweils das Hauptenergieverbindungselement (51) aufweisen, wobei die elektrischen Leitungen (45) der Verbindungsanordnung (40) innerhalb des Grundkörpergehäuses (30) teilweise mit den Nebenanschlüssen (55) und teilweise mit den Hauptanschlüssen (50) elektrisch verbunden sind.

4. Verbindungsvorrichtung (10) nach einem der vorhergehenden Ansprüche,
**dadurch gekennzeichnet,**
**dass** die Verbindungsvorrichtung (10) ferner aufweist:
- mehrere oder genau eine Nebenanschlussfläche (22), die in einem weiteren definierten Winkel (W2) zur jeweiligen Hauptanschlussfläche (21) angeordnet ist, und an welcher die Nebenanschlüsse (55) angeordnet sind, und/oder dass die Nebenanschlüsse (55) an der wenigstens einen Führungsfläche (80) angeordnet sind.

5. Verbindungsvorrichtung (10) nach einem der vorhergehenden Ansprüche,
**dadurch gekennzeichnet,**
**dass** die Nebenanschlüsse (55) in Relation zu den Hauptanschlüssen (50) unterschiedlich ausgerichtet sind, so dass bei der Montage eine mechanische und/oder elektrische Kontaktierung zwischen dem Funktionsmodul (200) und den Haupt- und Nebenanschlüssen (55) aus unterschiedlichen Richtungen erfolgt, vorzugsweise in mehr als einer Achse, wobei die wenigstens eine Führungsfläche (80) eine mechanische Führung in einer Einschubrichtung (ER) und/oder in einer Breitenrichtung der Verbindungsvorrichtung (10) bereitstellt, um die Kontaktierung mit den Hauptanschlüssen (50) in der Einschubrichtung (ER) zu unterstützen, wobei die Führungsfläche (80) vorzugsweise eine Bewegung der Funktionsmodule (200) bei der Montage in einer zur Einschubrichtung (ER) abweichenden Richtung begrenzt.

6. Verbindungsvorrichtung (10) nach einem der vorhergehenden Ansprüche,
**dadurch gekennzeichnet,**
**dass** die elektrischen Leitungen (45) der Verbindungsanordnung (40) die nachfolgenden Leitungen (45) umfassen:
- Hauptenergieleitungen (41), die dazu ausgebildet sind, den Hauptenergiefluss mit einer Wechselspannung bis zu 1000 Volt und/oder einer Gleichspannung bis zu 1500 Volt und/oder mit einer Wechselspannung im Bereich von 70 Volt bis 1000 Volt und/oder mit einer Gleichspannung im Bereich von 130 Volt bis 1500 Volt, und bevorzugt mit einer Wechselspannung von im Wesentlichen 400 Volt oder einer Gleichspannung im Bereich von 650 V bis 700 V, bereitzustellen, vorzugsweise, um wenigstens eines der elektrischen Geräte (300) mit Energie zu versorgen,
- Hilfsenergieleitungen (42), die dazu ausgebildet sind, den Hilfsenergiefluss mit einer Wechselspannung bis zu 50 Volt und/oder einer Gleichspannung bis zu 120 Volt und/oder mit einer Wechselspannung im Bereich von 0,01 Volt bis 50 Volt und/oder mit einer Gleichspannung im Bereich von 0,01 Volt bis 120 Volt, und bevorzugt mit einer Gleichspannung von im Wesentlichen 24 V oder 48 V, bereitzustellen, vorzugsweise, um eine Energieversorgung für wenigstens eines der Funktionsmodule (200) und/oder für eine Kommunikation mit wenigstens einem der elektrischen Geräte (300) bereitzustellen, bevorzugt für einen Feldbus,
- Datenleitungen (43), die dazu ausgebildet sind, ein Daten- und vorzugsweise Feldbussignal zu übertragen, vorzugsweise zur Kommunikation mit wenigstens einem der elektrischen Geräte (300),
wobei vorzugsweise vorgesehen ist,
**dass** die Hauptenergieleitungen (41) und die Hilfsenergieleitungen (42) und/oder die Datenleitungen (43) in getrennten Kanälen (25) des Grundkörpers (20) angeordnet und bevorzugt durch eine Trennwand (31) voneinander getrennt sind.

7. Verbindungsvorrichtung (10) nach einem der vorhergehenden Ansprüche,
**dadurch gekennzeichnet,**
**dass** der definierte Winkel (W1) und vorzugsweise auch der weitere definierte Winkel (W2) im Wesentlichen 90 Grad betragen, wobei vorzugsweise die jeweilige Führungsfläche (80) mit der einen oder mindestens einer der Hauptanschlussflächen (21) verbunden ist und eine Verlängerung der jeweiligen Hauptanschlussfläche (21) darstellt.

8. Verbindungsvorrichtung (10) nach einem der vorhergehenden Ansprüche,
**dadurch gekennzeichnet,**
**dass** eine Kontaktierung zwischen einer Verbinderanordnung (250,255) eines der Funktionsmodule (200), umfassend einen Funktionsmodulhauptverbinder (250) und einen Funktionsmodulnebenverbinder (255), und einer Anschlussanordnung (50,55) des Grundkörper (20), umfassend einen der Hauptanschlüsse (50) und einen der Nebenanschlüsse (55), in mehr als einer Achse erfolgt.

9. Verbindungsvorrichtung (10) nach einem der vorhergehenden Ansprüche,
**dadurch gekennzeichnet,**
**dass** das Grundkörpergehäuse (30) mehrteilig ausgebildet ist und die jeweilige Hauptanschlussfläche (21) und Führungsfläche (80) und insbesondere die Nebenanschlussfläche (22) ausbildet, wobei das Grundkörpergehäuse (30) im Wesentlichen L- oder U-förmig ausgebildet ist, wobei die Teile des Grundkörpergehäuses (30) form- und/oder kraftschlüssig miteinander verbunden sind.

10. Verbindungsvorrichtung (10) nach einem der vorhergehenden Ansprüche,
**dadurch gekennzeichnet,**
**dass** das Grundkörpergehäuse (30) einteilig ausgebildet ist und die jeweilige Hauptanschlussfläche (21) und Führungsfläche (80) und insbesondere die Nebenanschlussfläche (22) ausbildet, wobei das Grundkörpergehäuse (30) im Wesentlichen L- oder U-förmig ausgebildet ist.

11. Verbindungsvorrichtung (10) nach einem der vorhergehenden Ansprüche,
**dadurch gekennzeichnet,**
**dass** wenigstens ein Dichtmittel (28) im Anschlussbereich (A) vorgesehen ist, um den Anschlussbereich (A) abzudichten.

12. Verbindungsvorrichtung (10) nach einem der vorhergehenden Ansprüche,
**dadurch gekennzeichnet,**
**dass** wenigstens eine Aufnahme (35) für ein Befestigungselement (36), vorzugsweise für eine Schraube, vorgesehen ist, wobei die Aufnahme (35), vorzugsweise eine Gewindebohrung, mit einem Winkel (W3), vorzugsweise im Bereich von 10 ° bis 80 °, zur Hauptanschlussfläche (21) im Grundkörpergehäuse (30) ausgebildet ist, um eine schräge Befestigung und vorzugsweise Verschraubung des jeweiligen Funktionsmoduls (200) mit dem Grundkörpergehäuse (30) bereitzustellen.

13. Automatisierungsplattform (10), aufweisend eine Verbindungsvorrichtung (10) nach einem der vorhergehenden Ansprüche sowie die mehreren Funktionsmodule (200).

14. Verfahren zum Betreiben einer Verbindungsvorrichtung (10) zur Bereitstellung einer dezentralen Automatisierungsplattform (1), wobei die nachfolgenden Schritte vorgesehen sind:
- Bereitstellen einer Anordnung von mehreren Haupt- und Nebenanschlüssen (50,55), die zum elektrischen Anschluss von mehreren Funktionsmodulen (200) in einem Anschlussbereich (A) der Verbindungsvorrichtung (10) vorgesehen sind,
- Bereitstellen von mehreren oder genau einer Hauptanschlussfläche (21), an welcher zumindest die Hauptanschlüsse (50) angeordnet sind,
- Bereitstellen wenigstens einer Führungsfläche (80), die in einem definierten Winkel (W1) zur jeweiligen Hauptanschlussfläche (21) angeordnet ist, um die Funktionsmodule (200) in den Anschlussbereich (A) mechanisch zu führen und damit eine Montage der Funktionsmodule (200) zu unterstützen, die zum Anschluss an die Haupt- und/oder Nebenanschlüsse (50,55) vorgesehen ist,
- Bereitstellen eines Grundkörpers (20) mit einem Grundkörpergehäuse (30) und mit einer Verbindungsanordnung (40), wobei die Verbindungsanordnung (40) mit den Haupt- und/oder Nebenanschlüssen (50,55) elektrisch verbunden ist, um eine elektrische Verbindung für zumindest einen Teil der angeschlossenen Funktionsmodule (200) untereinander bereitzustellen,
- Bereitstellen elektrischer Leitungen (45) der Verbindungsanordnung (40), die im Grundkörpergehäuse (30) angeordnet sind, um einen Hauptenergiefluss, einen Hilfsenergiefluss und einen Datenfluss für die angeschlossenen Funktionsmodule (200) bereitzustellen, um die Automatisierungsplattform (1) zur Ansteuerung von elektrischen Geräten (300) einer industriellen Anlage zu betreiben.

15. Funktionsmodul (200) zur Bereitstellung wenigstens einer Funktion für eine elektrische Anlage, wobei das Funktionsmodul (200) dazu ausgebildet ist, mit einer Verbindungsvorrichtung (10) nach einem der Ansprüche 1 bis 12 eine dezentrale Automatisierungsplattform (1) bereitzustellen, wobei das Funktionsmodul (200) eine Verbinderanordnung (250,255) umfasst, die einen Funktionsmodulhauptverbinder (250) und einen Funktionsmodulnebenverbinder (255) aufweist, wobei der Funktionsmodulhauptverbinder (250) zur Kontaktierung mit einem der Hauptanschlüsse (50) der Verbindungsvorrichtung (10) ausgebildet ist, und wobei der Funktionsmodulnebenverbinder (255) zur Kontaktierung mit einem der Nebenanschlüsse (55) der Verbindungsvorrichtung (10) ausgebildet ist.
